# EUROPEAN PATENT APPLICATION

(11) **EP 4 618 722 A1**
(43) Date of publication of application: **17.09.2025**
(21) Application number: 25160224.9
(22) Date of filing: 26.02.2025
(51) Int. Cl.: H10D 64/01, H10B 43/27, H10B 51/20, H10D 30/01, H10D 64/68

(54) **DUAL SWITCHING MEMORY DEVICE AND METHOD OF MANUFACTURING THE SAME**

(30) Priority: 15.03.2024 KR 20240036372; 25.09.2024 KR 20240129920
(71) Applicant: Korea Advanced Institute of Science and Technology, Daejeon 34141 (KR)
(72) Inventor: CHO, Byung Jin, 34141 Daejeon (KR); PARK, YoungKeun, 34141 Daejeon (KR); JEONG, Jaejoong, 34141 Daejeon (KR); KANG, Daehyun, 34141 Daejeon (KR); KIM, Sheunghun, 34141 Daejeon (KR); CHU, Jun Hong, 34141 Daejeon (KR)
(74) Representative: Mathys & Squire

(57) **Abstract**

Provided are a dual switching memory device and a method of manufacturing the same, and in particular, a dual switching memory device and a method of manufacturing the same capable of increasing thermal stability during a manufacturing process and improving an operating speed and a memory window of the memory device. An object of the present invention is to increase thermal stability in the process of a dual switching memory device and improve an operating speed and memory window of the memory device.

## Description

### CROSS-REFERENCE TO RELATED APPLICATIONS

This application claims priority under 35 U.S.C. §119 to Korean Patent Application No. 10-2024-0036372, filed on March 15th, 2024, and No. 10-2024-0129920, filed on September 25th in the Korean Intellectual Property Office, the disclosure of which is incorporated herein by reference in its entirety.

### TECHNICAL FIELD

The following disclosure relates to a dual switching memory device and a method of manufacturing the same, and in particular, to a dual switching memory device and a method of manufacturing the same capable of increasing thermal stability during a manufacturing process and improving an operating speed and a memory window of the memory device.

### BACKGROUND

Currently, demand for memory semiconductors has increased explosively due to the 4th industrial revolution. As the number of Internet-of-things (IoT) devices has increased explosively, demand for memory in edge devices including smartphones has increased, and the amount of data that needs to be handled has increased explosively as deep learning has been utilized.

In order to keep up with this technological trend, nonvolatile memory semiconductors require high integration and excellent memory performance, and 3D NAND flash memory is far superior to other methods in terms of device integration, and therefore has led the nonvolatile memory market.

3D NAND flash memory is not only playing the role of a simple nonvolatile memory, but is also attracting attention as a computing-in-memory (CIM) device in the upcoming AI era. CIM devices perform multiply and accumulation (MAC) operations, which are the core operations of deep learning, at the memory stage, and may operate more efficiently because frequent data transfer between logic and memory is reduced.

In the latest trend of devices in which memory performs even operations, it is more essential than ever to perform memory read, write, and erase operations as quickly as possible and store a large amount of information (e.g. 4 bits/cell) in a single device.

Meanwhile, a dual switching memory device has a memory window that is twice or more that of existing charge trap flash memory devices because a remanent polarization of the ferroelectric and a charge captured in a charge trap layer cause a change in a threshold voltage in the same direction. This may solve the problem of reliability degradation that occurs when applying a quad level cell (QLC). However, HfZrO₂, a commonly used ferroelectric material, has a disadvantage in that it is vulnerable to high-temperature processes. In the 3D NAND flash memory process, a gate insulating film is deposited, a channel structure is then deposited, and thereafter, high-temperature processes, such as source/drain activation, are accompanied. Here, there is a problem that the leakage current characteristics and ferroelectricity of HfZrO₂ are deteriorated due to a subsequent process exceeding 900°C.

### SUMMARY

An exemplary embodiment of the present invention is directed to increasing thermal stability in the process of a dual switching memory device and improving an operating speed and memory window of the memory device.

In one general aspect, a dual switching memory device includes: a blocking layer positioned on a channel structure; a charge trap layer positioned on the blocking layer and capturing an injected charge; a tunnel layer positioned on the charge trap layer; and a gate electrode positioned on the tunnel layer and to which an ON voltage and an OFF voltage from a gate bias circuit are applied, wherein the blocking layer includes a ferroelectric material so that both charge trapping and ferroelectric polarization switching are performed.

According to an exemplary embodiment, the ferroelectric material may be aluminum-doped hafnium oxide (Al-doped HfO₂).

According to an exemplary embodiment, a composition ratio of hafnium and aluminum of the aluminum-doped hafnium oxide (Al-doped HfO₂) may be T_{Hf}:1(Al), and the T_{Hf} may be a natural number of 20 or more and 26 or less.

According to an exemplary embodiment, the composition ratio of hafnium and aluminum may be 23(Hf):1(Al).

According to an exemplary embodiment, an atomic concentration of hafnium in the aluminum-doped hafnium oxide (Al-doped HfO₂) may be 35%, and an atomic concentration of aluminum in the aluminum-doped hafnium oxide (Al-doped HfO₂) may be 1.6%.

In another general aspect, a method of manufacturing a dual switching memory device includes: (a) alternately stacking a word line and an insulating film; (b) forming a cylindrical hole in a center of the stacked word line and insulating film and forming a tunnel layer on an inner circumferential surface of the hole; (c) forming a charge trap layer on the inner circumferential surface of the tunnel layer; (d) forming a blocking layer on an inner circumferential surface of the charge trap layer; (e) forming a channel structure on an inner circumferential surface of the blocking layer; and (f) removing the insulating film and depositing a metal along the word line to form a gate electrode, wherein the blocking layer includes a ferroelectric material so that both charge trapping and ferroelectric polarization switching are performed.

According to an exemplary embodiment, the ferroelectric material may be aluminum-doped hafnium oxide (Al-doped HfO₂).

According to an exemplary embodiment, a composition ratio of hafnium and aluminum of the aluminum-doped hafnium oxide (Al doped HfO₂) may be T_{Hf}:1(Al), and the T_{Hf} may be a natural number of 20 or more and 26 or less.

According to an exemplary embodiment, a composition ratio of hafnium and aluminum may be 23(Hf):1(Al).

According to an exemplary embodiment, an atomic concentration of hafnium in the aluminum-doped hafnium oxide (Al-doped HfO₂) may be 35%, and an atomic concentration of aluminum in the aluminum-doped hafnium oxide (Al-doped HfO₂) may be 1.6%.

Other features and aspects will be apparent from the following detailed description, the drawings, and the claims.

### BRIEF DESCRIPTION OF THE DRAWINGS

FIG. 1 is a configuration diagram illustrating a configuration of a dual switching memory device according to an exemplary embodiment of the present invention.
**FIG.** 2 is a graph illustrating ferroelectric characteristics according to an aluminum concentration of a dual switching memory device according to an exemplary embodiment of the present invention.
**FIG.** 3 is a graph illustrating the relationship between an electric polarization and voltage according to a composition ratio of hafnium and aluminum of a dual switching memory device according to an exemplary embodiment of the present invention.
**FIG.** 4 is a flowchart illustrating a method of manufacturing a dual switching memory device according to an exemplary embodiment of the present invention.
**FIG.** 5 is a cross-sectional view of a dual switching memory device according to an exemplary embodiment of the present invention.

### DETAILED DESCRIPTION OF EXEMPLARY EMBODIMENTS

The aspects, features, and advantages of the disclosure will become apparent from the following description of the exemplary embodiments with reference to the accompanying drawings, which are set forth hereinafter. The specific structures and functional description will be only provided for the purpose of illustration of the exemplary embodiments according to the concept of the invention, so that the exemplary embodiments of the invention may be embodied in many different forms and should not be construed as being limited to the exemplary embodiments set forth herein. The exemplary embodiments according to the concept of the invention may be changed to diverse forms, so that the invention will be described and illustrated with reference to specific exemplary embodiments. However, it should be understood that the exemplary embodiments according to the concept of the invention are not intended to limit the invention to the specific exemplary embodiments disclosed, but they include all the modifications, equivalences, and substitutions, which are included in the scope and spirit of the invention. It will be understood that although the terms "first," "second," etc. may be used herein to describe various devices, these devices should not be limited by these terms. These terms are only used to distinguish one device from another device. Thus, a first device discussed below could be termed a second device and vice versa without departing from the nature of the disclosure. It will be understood that when a device is referred to as being "connected or coupled" to another device, it may be directly connected or coupled to the other device or intervening devices may be present therebetween. In contrast, when a device is referred to as being "directly connected" or "directly coupled" to another device, there are no intervening devices present. Other expressions, such as "between," "directly between," "adjacent," or "directly adjacent" should be understood in a similar manner. The terminology used herein is for the purpose of describing particular exemplary embodiments only and is not intended to limit the invention. As used herein, the singular forms "a," "an" and "the" are intended to include the plural forms as well, unless the context clearly indicates otherwise. It will be further understood that the terms "comprises" and/or "comprising," or "includes" and/or "including," when used in this specification, specify the presence of stated features, integers, steps, operations, devices and/or components, but do not preclude the presence or addition of one or more other features, integers, steps, operations, devices, components and/or groups thereof. Unless otherwise defined, the meaning of all terms including technical and scientific terms used herein are the same as those commonly understood by one of ordinary skill in the art to which the disclosure pertains. It will be further understood that terms, such as those defined in commonly used dictionaries, should be interpreted as having a meaning which is consistent with their meaning in the context of the relevant art and the disclosure, and will not be interpreted in an idealized or overly formal sense unless expressly so defined herein. Hereinafter, exemplary embodiments will be described in detail with reference to the accompanying drawings. The same reference numerals indicated in the drawings refer to similar devices throughout.

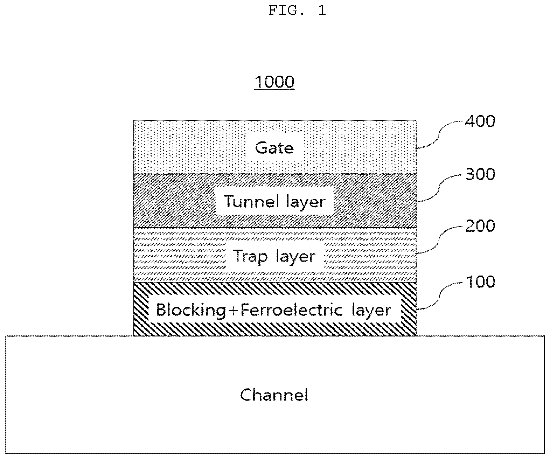

FIG. 1 is a configuration diagram illustrating a configuration of a dual switching memory device according to an exemplary embodiment of the present invention.

Referring to FIG. 1, a dual switching memory device 1000 according to an exemplary embodiment of the present invention includes a blocking layer 100 positioned on a channel structure, a charge trap layer 200 positioned on the blocking layer 100, a tunnel layer 300 positioned on the charge trap layer 200, and a gate electrode 400 positioned on the tunnel layer 300. Here, the channel structure may include a general semiconductor material including single crystal silicon, polysilicon, or oxide semiconductor.

Here, the dual switching memory device 1000 is configured to perform electron injection through the gate electrode 400, rather than electron injection through a channel in the existing charge trap memory device.

In the case of the existing charge trap memory device, a positive gate voltage is applied to the gate electrode 400 so that electrons are injected from the channel structure side and a V_{FB} increases.

Here, the V_{FB} refers to a gate voltage required for a band of the channel structure to be in a flat state.

However, in the case of the existing ferroelectric memory device, the V_{FB} decreases when a positive gate voltage is applied.

Therefore, by configuring a structure in which electrons are injected through a negative gate voltage, a direction in which the V_{FB} changes according to the gate voltage of the ferroelectric memory device and the charge trap memory may be aligned.

In addition, the blocking layer 100 corresponds to a blocking layer portion of the charge trap memory device, and in the present invention, the blocking layer of the existing charge trap memory device is formed of a ferroelectric material. In particular, the dual switching memory device 1000 according to the present invention may use aluminum-doped hafnium oxide (Al-doped HfO₂) for thermal stability during the process.

In addition, a thickness of the blocking layer 100 is preferably greater than a thickness of the charge trap layer 200 and a thickness of the tunnel layer 300 described below, and for example, the thickness of the blocking layer 100 is preferably about 10 nm.

Meanwhile, the charge trap layer 200 is positioned on the blocking layer 100 and is provided to capture charges injected from the gate electrode 400. This means that, when a negative gate voltage is formed in the gate electrode 400, charges passing through the tunnel layer 300 are prevented from moving to the channel structure (Si) by the blocking layer 100 and are captured on the charge trap layer 200.

The charge trap layer 200 is preferably silicon nitride (Si₃N₄) and may also be formed of one or a combination of aluminum oxide, zirconium oxide, hafnium oxide, lanthanum oxide, and niobium oxide.

In addition, when the charge trap layer 200 is formed of silicon nitride (Si₃N₄), it is preferable to form the charge trap layer 200 by a chemical vapor deposition (CVD) method using SiH₄ gas or SiCl₂H₂ gas and NH₃ gas at 400°C to 800°C.

In addition, it is preferable to form silicon nitride (Si₃N₄) so that the ratio of nitrogen to silicon is 0.6 to 1.45 (0.6<N/Si<1.45).

The thickness of the charge trap layer 200 is preferably formed to be the same as or greater than that of the tunnel layer 300 described below, and for example, the thickness of the charge trap layer 200 is preferably 5 nm to 8 nm.

Meanwhile, the tunnel layer 300 is positioned above the charge trap layer 200 and below the gate electrode 400, and as described above, when a negative gate voltage is applied to the gate electrode 400, the charge of the gate electrode 400 moves to the charge trap layer 200 via the tunnel layer 300.

The tunnel layer 300 is provided as an energy barrier layer according to the tunneling of charges and is preferably formed of an oxide film, such as silicon oxide (SiO₂).

In addition, it is preferable that the formation process of the tunnel layer 300 is performed by a thermal oxidation process, a radical oxidation process, or additionally by Atomic Layer Deposition (ALD) and Chemical Vapor Deposition (CVD). The thickness of the tunnel layer 300 is formed to be less than the thickness of the blocking layer as described above and equal to or less than the thickness of the charge trap layer 200, and the thickness of the tunnel layer 300 is preferably 4 nm to 6 nm, for example.

Meanwhile, the gate electrode 400 is located above the tunnel layer 300 and an ON voltage and OFF voltage from a gate bias circuit are applied to the gate electrode 400. In the present invention, as described above, the negative gate voltage corresponds to the ON voltage, and when the negative gate voltage is applied, the charge of the gate electrode 400 moves to the charge trap layer 200 via the tunnel layer 300.

It is preferable that the gate electrode 400 includes a conductive nitride, such as TiN, TaN, and WN.

In addition, the gate electrode 400 may include a conductive oxynitride (for example, TiON, etc.) or a combination thereof (for example, TiSiN, TiAlON, etc.), and may include polysilicon heavily doped with impurities.

Of course, the gate electrode 400 may include a conductive metal, such as platinum (Pt), ruthenium (Ru), iridium (Ir), silver (Ag), aluminum (Al), titanium (Ti), tantalum (Ta), tungsten (W), silicon (Si), copper (Cu), nickel (Ni), cobalt (Co), or molybdenum (Mo), or alloys thereof, other than the nitride form as described above, and these materials are examples and the present invention is not limited thereto.

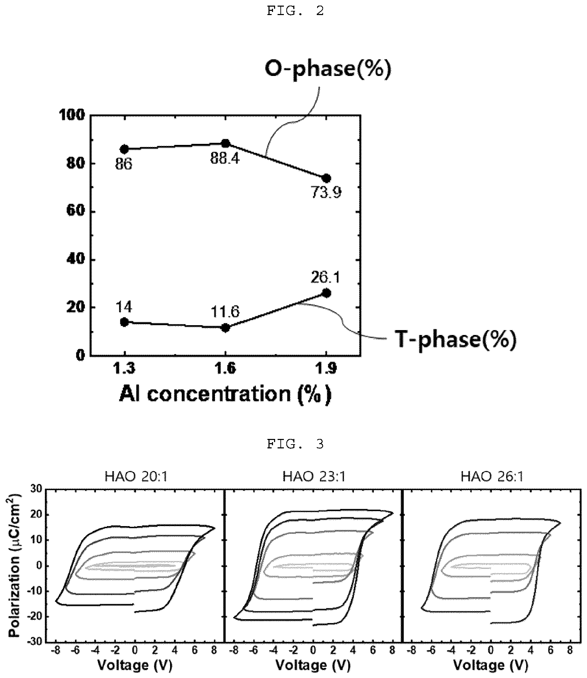

FIG. 2 is a graph illustrating ferroelectric characteristics according to an aluminum concentration of the dual switching memory device according to an exemplary embodiment of the present invention.

Referring to FIG. 2, the dual switching memory device 1000 according to an exemplary embodiment of the present invention has ferroelectric characteristics varying depending on an aluminum concentration of an aluminum-doped hafnium oxide (Al-doped HfO₂), which is the ferroelectric material of the blocking layer 100.

Here, an O-phase (orthorhombic phase) has a crystal structure in which three different axes are perpendicular to each other and exhibits ferroelectric characteristics, and a T-phase (tetragonal phase) has a crystal structure in which three axes are perpendicular to each other and two of them are the same and exhibits electrical characteristics similar to antiferroelectricity. In other words, greater O-phase and smaller T-phase exhibit higher ferroelectric characteristics.

It can be confirmed that the dual switching memory device 1000 according to the present invention exhibits the most efficient ferroelectricity when the aluminum concentration of the aluminum-doped hafnium oxide (Al-doped HfO₂) is 1.3% to 1.9%. In particular, it can be confirmed that the ferroelectricity is the highest in a section with an aluminum concentration of 1.6%, in which a composition ratio of hafnium and aluminum is 23(Hf) :1 (Al).

FIG. 3 is a graph illustrating the relationship between an electric polarization (P) and voltage (V) according to the composition ratio of hafnium and aluminum of a dual switching memory device according to an exemplary embodiment of the present invention.

Referring to FIG. 3, the PV characteristics of the dual switching memory device 1000 according to an exemplary embodiment of the present invention vary depending on the composition ratio of hafnium and aluminum of the aluminum-doped hafnium oxide (Al-doped HfO₂), which is a ferroelectric material of the blocking layer 100, and accordingly, the memory window also varies.

As described above with reference to FIG. 2, the blocking layer 100 of the dual switching memory device 1000 according to the present invention exhibits the highest efficiency ferroelectric characteristics in the range of an aluminum concentration from 1.3% to 1.9%, which is expressed as a composition ratio of hafnium and aluminum corresponding to 20(Hf):1(Al) to 26(Hf):1(Al). That is, when the composition ratio of hafnium and aluminum is 20(Hf) :1(Al), among the substances constituting aluminum-doped hafnium oxide (Al-doped HfO2), hafnium is 34% and aluminum is 1.9%. When the composition ratio of hafnium and aluminum is 23(Hf):1(Al), hafnium is 35% and aluminum is 1.6% of the substances constituting aluminum-doped hafnium oxide (Al-doped HfO₂), and when the composition ratio of hafnium and aluminum is 26(Hf):1(Al), hafnium is 35% and aluminum is 1.3% of the substances constituting aluminum-doped hafnium oxide (Al-doped HfO₂).

As illustrated in FIG. 3, the dual switching memory device 1000 according to the present invention exhibits the largest memory window when the composition ratio of hafnium and aluminum is 23(Hf) :1(Al), that is, when hafnium is 35% and aluminum is 1.6% of the substances constituting the aluminum-doped hafnium oxide (Al-doped HfO₂).

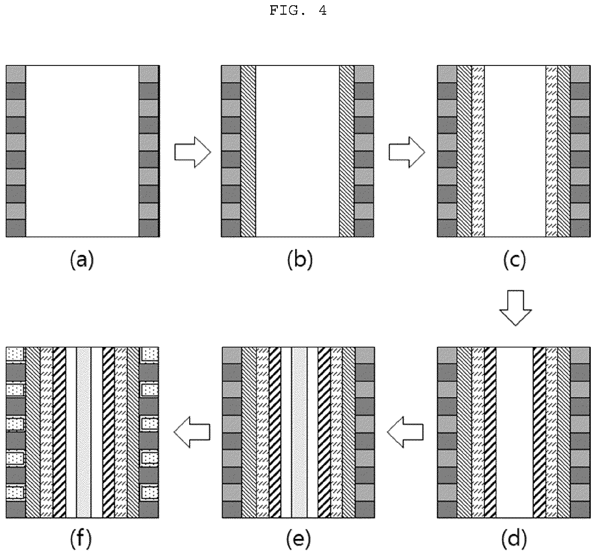

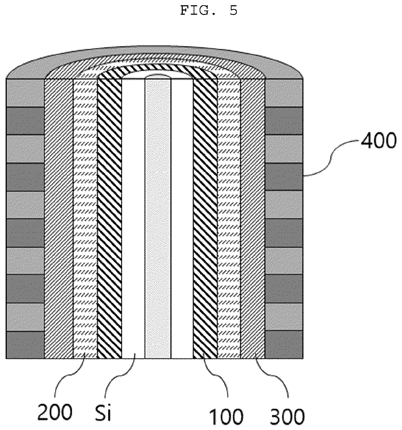

FIG. 4 is a flowchart illustrating a method of manufacturing a dual switching memory device according to an exemplary embodiment of the present invention, and FIG. 5 is a cross-sectional view of a dual switching memory device according to an exemplary embodiment of the present invention.

FIG. 4 is a cross-sectional view illustrating a method of manufacturing a dual switching memory device according to an exemplary embodiment of the present invention in sequence, and referring to FIGS. 4 and 5, the method may include (a) an operation of alternately stacking a word line and an insulating film, (b) an operation of forming a cylindrical hole in the center of the stacked word line and insulating film and forming the tunnel layer 300 on an inner circumferential surface of the hole, (c) an operation of forming the charge trap layer 200 on an inner circumferential surface of the tunnel layer 300, (d) an operation of forming the blocking layer 100 on an inner circumferential surface of the charge trap layer 200, (e) an operation of forming the channel structure (Si) on an inner circumferential surface of the blocking layer 100, and (f) an operation of removing the insulating film and depositing a metal along the word line to form the gate electrode 400.

The blocking layer 100 corresponds to the blocking layer portion of the charge trap memory device, and the present invention configures the blocking layer of the existing charge trap memory device with a ferroelectric material. In particular, the dual switching memory device 1000 according to the present invention may use aluminum-doped hafnium oxide (Al-doped HfO₂) for thermal stability during the process.

In addition, a thickness of the blocking layer 100 is preferably greater than a thickness of the charge trap layer 200 and a thickness of the tunnel layer 300 described below, and for example, the thickness of the blocking layer 100 is preferably about 10 nm.

Meanwhile, the charge trap layer 200 is positioned on the blocking layer 100 and is provided to capture charges injected from the gate electrode 400. This means that, when a negative gate voltage is formed on the gate electrode 400, charges passing through the tunnel layer 300 are prevented from moving to the channel structure (Si) by the blocking layer 100 and are captured on the charge trap layer 200.

The charge trap layer 200 is preferably silicon nitride (Si₃N₄), but may also be formed of one or a combination of aluminum oxide, zirconium oxide, hafnium oxide, lanthanum oxide, and niobium oxide.

In addition, when the charge trap layer 200 is formed of silicon nitride (Si₃N₄), it is preferable to form the charge trap layer 200 by a chemical vapor deposition (CVD) method using SiH₄ gas or SiCl₂H₂ gas and NH₃ gas at 400°C to 800°C.

In addition, it is preferable that silicon nitride (Si₃N₄) is formed so that the nitrogen to silicon ratio is 0.6 to 1.45 (0.6<N/Si<1.45).

It is preferable that the thickness of the charge trap layer 200 is formed to be the same as or greater than that of the tunnel layer 300 described below, and for example, the thickness of the charge trap layer 200 is preferably 5 nm to 8 nm.

Meanwhile, the tunnel layer 300 is positioned above the charge trap layer 200 and below the gate electrode 400, and as described above, when a negative gate voltage is applied to the gate electrode 400, the charge of the gate electrode 400 is provided to move to the charge trap layer 200 via the tunnel layer 300.

The tunnel layer 300 is provided as an energy barrier layer according to the tunneling of charges and is preferably formed of an oxide film, such as silicon oxide (SiO₂).

In addition, the formation process of the tunnel layer 300 is preferably performed by a thermal oxidation process, a radical oxidation process, or additionally by Atomic Layer Deposition (ALD) and Chemical Vapor Deposition (CVD). The thickness of the tunnel layer 300 is preferably formed to be less than the thickness of the blocking layer as described above and equal to or less than the thickness of the charge trap layer 200, and the thickness of the tunnel layer 300 is preferably 4 nm to 6 nm, for example.

Meanwhile, the gate electrode 400 is positioned on top of the tunnel layer 300, and the ON voltage and OFF voltage from a gate bias circuit are applied thereto. In the present invention, as described above, the negative gate voltage corresponds to the ON voltage, and when the negative gate voltage is applied, the charge of the gate electrode 400 moves to the charge trap layer 200 via the tunnel layer 300.

It is preferable that the gate electrode 400 include a conductive nitride, such as TiN, TaN, and WN.

In addition, the gate electrode 400 may include a conductive oxynitride (for example, TiON, etc.) or combinations thereof (for example, TiSiN, TiAlON, etc.), and the gate electrode 400 may include polysilicon heavily doped with impurities.

Of course, the gate electrode 400 may include a conductive metal, such as platinum (Pt), ruthenium (Ru), iridium (Ir), silver (Ag), aluminum (Al), titanium (Ti), tantalum (Ta), tungsten (W), silicon (Si), copper (Cu), nickel (Ni), cobalt (Co), or molybdenum (Mo), or alloys thereof, other than the nitride form as described above, and these materials are examples and the present invention is not limited thereto.

According to the present invention, the blocking layer having excellent leakage current characteristics may be secured even in a high-temperature heat treatment process.

In addition, according to the present invention, the more memory window of the dual switching memory device may be secured.

In addition, according to the present invention, the ferroelectricity may be maintained without deterioration even in a high-temperature heat treatment process.

Although the preferred exemplary embodiments of the present invention have been described above, the exemplary embodiments disclosed in the present invention are not intended to limit the technical spirit of the present invention, but are only for description. Therefore, the technical spirit of the present invention includes not only each disclosed exemplary embodiment, but also a combination of the disclosed exemplary embodiments, and furthermore, the scope of the technical spirit of the present invention is not limited by these exemplary embodiments. In addition, those skilled in the art to which the present invention pertains may make many changes and modifications to the present invention without departing from the spirit and scope of the appended claims, and all such appropriate changes and modifications, as equivalents, are to be regarded as falling within the scope of the present invention.

### [Detailed Description of Main Elements]

100: blocking layer
200: charge trap layer
300: tunnel layer
400: gate electrode
1000: dual switching memory device

## Claims

1. A dual switching memory device comprising:
a blocking layer positioned on a channel structure;
a charge trap layer positioned on the blocking layer and capturing an injected charge;
a tunnel layer positioned on the charge trap layer; and
a gate electrode positioned on the tunnel layer and to which an ON voltage and an OFF voltage from a gate bias circuit are applied,
wherein the blocking layer includes a ferroelectric material so that both charge trapping and ferroelectric polarization switching are performed.

2. The dual switching memory device of claim 1, wherein the ferroelectric material is aluminum-doped hafnium oxide (Al-doped HfO₂).

3. The dual switching memory device of claim 2, wherein a composition ratio of hafnium and aluminum of the aluminum-doped hafnium oxide (Al-doped HfO₂) is T_{Hf}:1(Al), and the T_{Hf} is a natural number of 20 or more and 26 or less.

4. The dual switching memory device of claim 3, wherein the composition ratio of hafnium and aluminum is 23 (Hf):1(Al) .

5. The dual switching memory device of claim 4, wherein an atomic concentration of hafnium in the aluminum-doped hafnium oxide (Al-doped HfO₂) is 35%, and an atomic concentration of aluminum in the aluminum-doped hafnium oxide (Al-doped HfO₂) is 1.6%.

6. A method of manufacturing a dual switching memory device, the method comprising:
(a) alternately stacking a word line and an insulating film;
(b) forming a cylindrical hole in a center of the stacked word line and insulating film and forming a tunnel layer on an inner circumferential surface of the hole;
(c) forming a charge trap layer on the inner circumferential surface of the tunnel layer;
(d) forming a blocking layer on an inner circumferential surface of the charge trap layer;
(e) forming a channel structure on an inner circumferential surface of the blocking layer; and
(f) removing the insulating film and depositing a metal along the word line to form a gate electrode,
wherein the blocking layer includes a ferroelectric material so that both charge trapping and ferroelectric polarization switching are performed.

7. The method of claim 6, wherein the ferroelectric material is aluminum-doped hafnium oxide (Al-doped HfO₂).

8. The method of claim 7, wherein a composition ratio of hafnium and aluminum of the aluminum-doped hafnium oxide (Al-doped HfO₂) is T_{Hf}:1(Al), and the T_{Hf} is a natural number of 20 or more and 26 or less.

9. The method of claim 8, wherein the composition ratio of hafnium and aluminum is 23(Hf) :1(Al).

10. The method of claim 9, wherein an atomic concentration of hafnium in the aluminum-doped hafnium oxide (Al-doped HfO₂) is 35%, and an atomic concentration of aluminum in the aluminum-doped hafnium oxide (Al-doped HfO₂) is 1.6%.
